# DEMANDE DE BREVET EUROPEEN

(11) **EP 3 208 149 A1**
(43) Date de publication de la demande: **23.08.2017**
(21) Numéro de dépôt: 17156391.9
(22) Date de dépôt: 16.02.2017
(51) Int. Cl.: B60Q 1/32, B60Q 3/217, B60Q 3/82, H01H 36/00

(54) **DISPOSITIF DE DÉTECTION D'OUVERTURE ET DE FERMETURE D'UN OUVRANT DE VÉHICULE ET DISPOSITIF LUMINEUX COMPORTANT UN TEL DISPOSITIF DE DÉTECTION**

(30) Priorité: 16.02.2016 FR 1651243
(71) Demandeur: Metalplast, 75017 Paris (FR)
(72) Inventeur: DE SOUSA, José-Michel, 78200 Mantes-La-Jolie (FR)
(74) Mandataire: Santarelli

(57) **Abrégé**

L'invention porte sur un dispositif de détection d'ouverture et de fermeture d'un ouvrant de véhicule. Un corps principal du dispositif contient un capteur (4) de champ magnétique et un aimant (5) permanent agencés l'un par rapport à l'autre de sorte que :
- lorsque le corps principal est disposé sur une surface ferromagnétique et qu'aucun élément ferromagnétique n'est positionné au-dessus du dispositif, le champ magnétique (9) généré par l'aimant (5) est supérieur, au niveau du capteur (4), à un seuil de détection dudit capteur (4), et
- lorsque le corps principal est en présence d'un élément ferromagnétique d'un ouvrant de véhicule, positionné au-dessus en regard de l'aimant (5), le champ magnétique (9) est dévié par ledit élément ferromagnétique de sorte qu'il est inférieur, au niveau du capteur (4), au seuil de détection dudit capteur (4).

L'invention porte également sur un dispositif lumineux comportant un tel dispositif de détection et sur un enjoliveur lumineux de seuil de porte.

## Description

La présente invention concerne le domaine des dispositifs de détection d'ouverture et de fermeture d'un ouvrant de véhicule, notamment employés pour l'allumage et l'extinction d'un dispositif lumineux positionné dans un ouvrant de véhicules, notamment automobiles.

Elle concerne notamment les enjoliveurs lumineux positionnés dans l'encadrement d'un ouvrant, notamment les enjoliveurs lumineux de seuil de porte.

Les véhicules automobiles comportent des éléments distinctifs, esthétiques et fonctionnels, notamment des éléments lumineux. Il est connu d'équiper le seuil d'une portière ou porte d'un véhicule automobile d'une plaque également appelée enjoliveur de seuil de porte. L'enjoliveur de seuil de porte peut avoir une fonction de protection de la caisse du véhicule contre les rayures dans la zone très exposée du seuil d'une porte. Cette plaque a généralement avant tout une fonction esthétique, et peut présenter une inscription, un logo, et/ou une texture particulière (métal brossé, aspect fibre de carbone, etc.).

Des enjoliveurs de seuil de porte dit lumineux, éclairés ou rétroéclairés, sont par ailleurs connus dans l'état de la technique. Il s'agit d'enjoliveurs de seuils comportant une lame supérieure transparente ou translucide et une source lumineuse. Un masque opaque peut être interposé entre la source et la lame transparente ou translucide, le masque opaque comportant des ouvertures pour définir les zones éclairées de l'enjoliveur, pouvant correspondre à un logo, une marque, ou une inscription particulière.

L'enjoliveur étant invisible lorsque la porte est fermée, il n'est pas nécessaire et même désavantageux en matière de consommation électrique et de durabilité du dispositif de laisser l'enjoliveur de seuil lumineux allumé lorsque la portière est fermée. Par contre, le dispositif doit s'allumer dès le début de l'ouverture de la portière.

Il est connu d'employer un dispositif permettant de détecter la position, ouverte ou fermée de la porte. A cette fin, le contacteur de porte peut être employé. Néanmoins, cela nécessite un montage électrique supplémentaire, potentiellement complexe en seconde monte, afin de relier l'enjoliveur lumineux au signal issu du contacteur.

Il est par ailleurs connu un autre dispositif permettant de détecter la présence ou l'absence de la porte au-dessus du seuil. Un tel dispositif comporte un capteur de champ magnétique, par exemple un capteur magnéto-résistif, lié à l'enjoliveur de porte, et un aimant permanent lié à la porte du véhicule. Lorsque le capteur est sous l'influence d'un champ magnétique (généré par l'aimant) supérieur à un seuil de détection, le capteur émet un signal de détection. Lorsque l'aimant est suffisamment éloigné du capteur, le champ magnétique est sous le seuil de détection du capteur qui ne le détecte pas.

Un tel dispositif de détection permet une détection sans contact de l'ouverture et de la fermeture d'une porte, et peut être installé en seconde monte sur un véhicule. Il comporte cependant un certain nombre d'inconvénients. D'une part, l'aimant permanent devant être positionné au-dessus du capteur de champ magnétique pour être détecté, il est nécessaire qu'il existe entre la porte et le seuil de porte un écart supérieur au cumul de l'épaisseur de l'enjoliveur et de l'aimant. Par ailleurs, la bonne détection de l'ouverture et de la fermeture de la porte suppose un positionnement précis de l'aimant sur la portière. Un décalage de l'aimant ou de l'enjoliveur de seuil de porte, ou une perte de l'aimant, rend par ailleurs le dispositif inopérant.

Dans l'invention, il est proposé un dispositif de détection de l'ouverture et de la fermeture d'un ouvrant, c'est-à-dire de sa position soit ouverte soit fermée, pouvant notamment équiper un enjoliveur lumineux de seuil de porte de véhicule, résolvant au moins l'un de ces problèmes.

Ainsi, l'invention porte sur un dispositif de détection d'ouverture et de fermeture d'un ouvrant de véhicule comportant un corps principal contenant un capteur de champ magnétique. Le corps principal comporte une face inférieure et une face supérieure. Le corps principal contient en outre un aimant permanent, lesdits aimant et capteur étant agencés l'un par rapport à l'autre de sorte que :
- lorsque la face inférieure du corps principal est disposée sur une surface ferromagnétique et qu'aucun élément ferromagnétique n'est positionné à proximité de la face supérieure, le champ magnétique généré par l'aimant est supérieur, au niveau du capteur, à un seuil de détection dudit capteur, et
- lorsque le corps principal est en présence d'un élément ferromagnétique d'un ouvrant de véhicule, positionné en regard de l'aimant à proximité de la face supérieure, le champ magnétique est dévié par ledit élément ferromagnétique de sorte qu'il est inférieur, au niveau du capteur, au seuil de détection dudit capteur.

Ainsi, la position de la porte ou de tout autre ouvrant ferromagnétique ou comportant un élément ferromagnétique susceptible de dévier le champ magnétique de l'aimant est détecté par le capteur. Lorsque ce dernier ne détecte aucun champ magnétique, cela traduit une position fermée de l'ouvrant, et, lorsqu'il détecte un champ magnétique (supérieur à son seuil de détection), cela traduit une position ouverte de l'ouvrant.

L'aimant et le capteur peuvent être positionnés sensiblement dans un même plan parallèle à la face inférieure du corps principal du dispositif.

Le capteur peut être de type « capteur magnéto-résistif ». D'autres technologies de capteur de champ magnétique peuvent être employées.

L'invention porte également sur un dispositif lumineux dont l'allumage et l'extinction sont asservis à l'ouverture et la fermeture d'un ouvrant de véhicule comportant un dispositif de détection tel que précédemment décrit. Le dispositif lumineux comporte en outre une source électrique de lumière et une batterie, et est configuré de sorte que la source de lumière est alimentée par la batterie lorsque le capteur capte un champ magnétique supérieur à son seuil de détection, et n'est pas alimentée lorsque le capteur ne capte pas de champ magnétique supérieur à son seuil de détection.

La source de lumière du dispositif lumineux peut comporter au moins une diode électroluminescente. Elle peut comporter plusieurs diodes électroluminescentes. Alternativement, d'autres sources de lumière peuvent être employées. Par exemple la source de lumière peut comporter une ou plusieurs ampoules électriques, ou comporter un afficheur lumineux.

Dans un tel dispositif lumineux, le corps principal du dispositif de détection peut également former corps principal du dispositif lumineux. La face supérieure peut comporter au moins une ouverture permettant la sortie de lumière issue de la source lumineuse.

Le dispositif lumineux peut comporter un diffuseur optique adapté à répartir une lumière issue de la source de lumière de manière homogène sous l'ouverture de la face supérieure.

Le dispositif lumineux peut comporter en outre un masque comportant une zone opaque et une zone transparente, ledit masque obturant l'ouverture.

La zone transparente du masque correspond à la zone éclairée du dispositif, et peut former un logo, un symbole, et/ou toute inscription souhaitée.

Le dispositif lumineux peut comporter une carte électronique intégrant le capteur, la source lumineuse, et un dispositif de commande de l'alimentation de la source de lumière en fonction d'un signal issu du capteur.

L'invention porte enfin sur un enjoliveur lumineux de seuil de porte pour véhicule automobile comportant ou constitué d'un dispositif lumineux tel que précédemment décrit.

D'autres particularités et avantages de l'invention apparaîtront encore dans la description ci-après.

Aux dessins annexés, donnés à titre d'exemples non limitatifs :
- la figure 1 présente schématiquement selon une vue en trois dimensions un enjoliveur de seuil de porte d'un véhicule automobile et son environnement immédiat ;
- la figure 2 présente schématiquement selon une vue en coupe transversale un enjoliveur de seuil de porte conforme à l'état de la technique et son environnement immédiat ;
- la figure 3 présente schématiquement selon une vue en coupe identique à celle de la figure 2 un enjoliveur de seuil de porte comportant un dispositif de détection d'un ouvrant conforme à un mode de réalisation de l'invention ;

- la figure 4 présente un schéma de principe selon une vue en coupe longitudinale un enjoliveur de seuil de porte comportant un dispositif de détection d'un ouvrant conforme à un mode de réalisation de l'invention lorsqu'il ne détecte pas la présence d'un ouvrant ;
- la figure 5 présente le même schéma de principe que celui de la figure 4 lorsque le dispositif de détection d'ouvrant détecte un ouvrant.

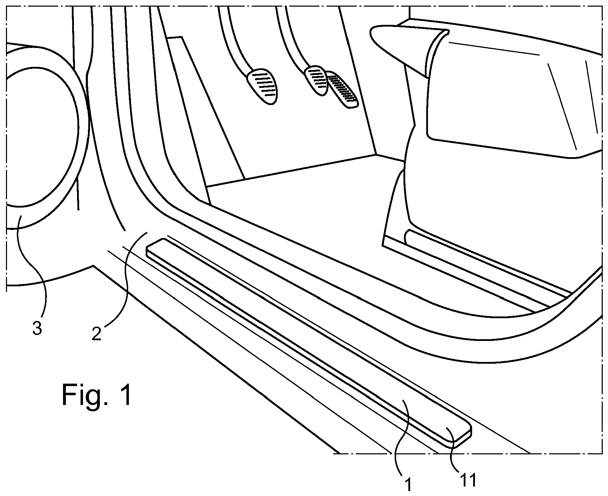

Tel qu'il apparait à la figure 1, un enjoliveur 1 de seuil de porte est un dispositif destiné à être installé sur le seuil 2 d'une porte 3 d'un véhicule automobile.

La porte 3 fait partie de l'ensemble des éléments dits « ouvrants » d'un véhicule, qui comporte les éléments mobiles par rapport à la caisse du véhicule, notamment les portes (également appelées portières), le hayon ou le volet de coffre du véhicule, et le capot moteur. Bien que décrite en relation avec la détection d'une porte de véhicule, le dispositif objet de l'invention est applicable à la détection de l'ouverture ou la fermeture de tout ouvrant.

L'enjoliveur de seuil de porte (ou autre ouvrant) a une fonction de protection du seuil 2 contre les rayures, mais il a en premier lieu une fonction esthétique. Un seuil éclairé permet une bonne visualisation du seuil, et offre un aspect attractif. Un logo ou une inscription particulière peut être rétroéclairé (par l'intérieur de l'enjoliveur) et apparaître avec un aspect lumineux sur une face supérieure 11 de l'enjoliveur 1. L'enjoliveur 1 de seuil de porte est de forme générale allongée, selon une direction dite longitudinale.

L'enjoliveur 1 de seuil de porte est fixé sur le seuil 2, par exemple par collage.

Dans le cadre d'un enjoliveur lumineux de seuil de porte, un dispositif permet de détecter si la porte est en position fermée ou ouverte, afin de n'éclairer l'enjoliveur lumineux que lorsque la porte est ouverte. La position fermée ou ouverte de la porte peut être détectée à l'aide d'un contacteur de porte, généralement déjà présent, ou en détectant la présence ou l'absence de la porte 3 au-dessus du seuil de porte.

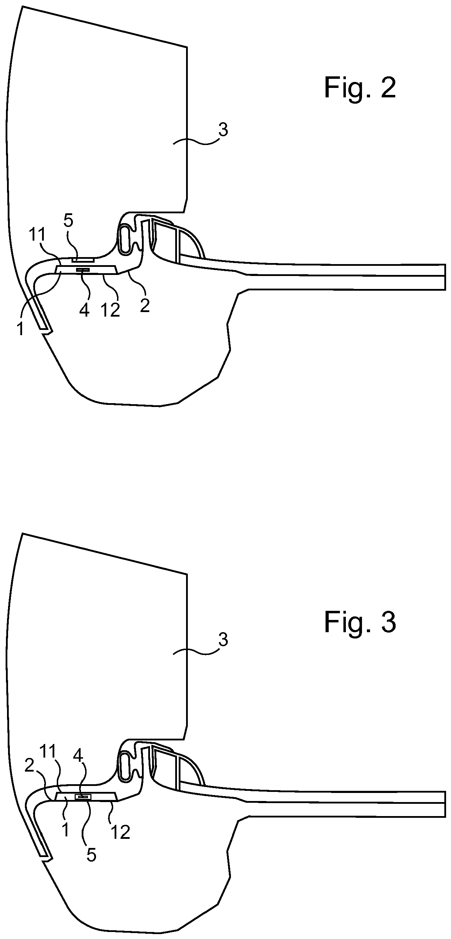

La figure 2 présente schématiquement selon une vue en coupe transversale (orthogonale à la direction d'extension longitudinale de l'enjoliveur) un enjoliveur de seuil de porte conforme à l'état de la technique et son environnement immédiat.

L'enjoliveur 1 est fixé par sa face inférieure 12 au seuil de porte 2. La face inférieure 12 et la face supérieure 11 sont sensiblement parallèles. L'enjoliveur comporte un capteur 4 de champ magnétique. Il est ici représenté en coupe au niveau du capteur 4 de champ magnétique.

Le capteur 4 de champ magnétique, qui peut également être appelé plus simplement capteur magnétique, peut être du type magnéto-résistif. Un capteur magnéto-résistif est basé sur le changement de résistance électrique d'un matériau ferromagnétique en fonction du champ magnétique appliqué.

Selon l'état de la technique, un aimant 5 permanent est fixé sur l'élément mobile dont la présence est à détecter, à savoir la porte 3. L'aimant 5 peut par exemple être collé, ou fixé à l'aide d'un adhésif double-face. Lorsque la porte est fermée, l'aimant est positionné au-dessus en regard du capteur 4 qui est sous l'influence d'un champ magnétique supérieur à son seuil de détection.

Il est ainsi nécessaire pour employer un enjoliveur 1 de seuil de porte (ou autre ouvrant) tel que représenté à la figure 2 et comportant le dispositif de détection d'ouvrant précédemment décrit que l'espace entre la porte et le seuil de porte soit supérieur à la somme de l'épaisseur (entre la face inférieure 12 et la face supérieure 11) de l'enjoliveur 1 au niveau du capteur 4 et de l'épaisseur de l'aimant 5. Par ailleurs, un positionnement précis de l'aimant lors du montage du seuil de porte 1 comportant un tel dispositif de détection est nécessaire au bon fonctionnement de l'ensemble. En cas de montage peu précis, ou si l'aimant se décale ou se décolle, la détection de la porte est peu fiable voire inopérante. Le dispositif de détection d'ouvrant procure alors une information erronée et l'enjoliveur 1 reste allumé porte fermée.

La figure 3 présente schématiquement selon une vue en coupe identique à celle de la figure 2 un enjoliveur de seuil de porte comportant un dispositif de détection d'un ouvrant conforme à un mode de réalisation de l'invention. De manière remarquable, l'enjoliveur de seuil de porte comporte un dispositif de détection d'ouverture d'un ouvrant conforme à un mode de réalisation de l'invention, et comporte ainsi dans un même corps principal le capteur 4 et l'aimant 5.

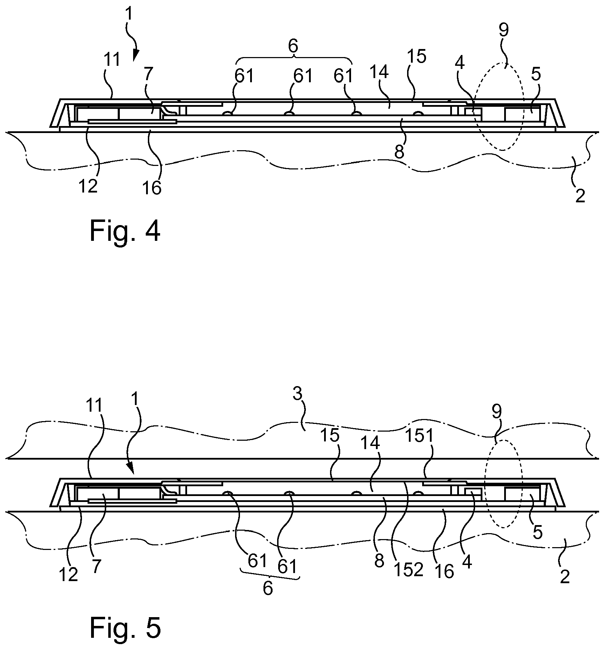

Les figures 4 et 5 détaillent sur un schéma de principe en coupe longitudinale (selon la direction longitudinale d'extension de l'enjoliveur 1 de seuil de porte) le fonctionnement du dispositif de détection contenu dans l'enjoliveur 1 de seuil de porte.

Le capteur 4 de champ magnétique et l'aimant 5 sont positionnés dans un même corps principal, qui est à la fois le corps principal du dispositif de détection et de l'enjoliveur 1. Le dispositif lumineux ici représenté, à savoir l'enjoliveur 1 de seuil de porte, comporte, outre le dispositif de détection d'ouverture d'une porte, une source de lumière 6. La source de lumière 6 est une source électrique. Elle peut comporter une ou plusieurs ampoules ou préférentiellement une ou plusieurs diodes électroluminescentes 61 (ou LED). La source de lumière peut être alimentée par une batterie 7. La batterie 7 peut être de tout type adapté à l'alimentation de la source de lumière. Par exemple, la batterie 7 peut comporter une ou plusieurs piles de type « bouton ». Une trappe (non représentée) par exemple ménagée dans la face supérieure 11 peut permettre le remplacement de la batterie. Dans une autre variante, le remplacement de la batterie peut être réalisé après désolidarisation de pièce formant la face supérieure 11 du reste du dispositif, typiquement par déclipsage de cette pièce.

Afin que la lumière puisse s'échapper de l'enjoliveur 1, sa face supérieure, qui est également la face supérieure 11 de son corps principal, comporte une ouverture 13. L'ouverture peut notamment présenter plus de la moitié de la surface de la face supérieure 11.

Un diffuseur optique 14, situé entre la source de lumière 6 et l'ouverture 13 de la face supérieure 11 permet d'homogénéiser la lumière sortant de l'ouverture 13 lorsque la source de lumière 6 est allumée. Le diffuseur optique 14 peut consister par exemple en une plaque ou substrat en polycarbonate, acrylique, verre, ou silice fondue, présentant une structure permettant la diffusion de la lumière le traversant.

Au-dessus de l'ouverture 13, un masque 15 permet de définir le logo et/ou l'inscription visible au niveau de la face supérieure 11 de l'enjoliveur 1 lorsque la source de lumière est en fonctionnement.

Le masque 15 comporte avantageusement une lame transparente comportant un côté inférieur 151 et un côté supérieur 152, le côté inférieur 151 présentant un masquage opaque définissant le logo et/ou l'inscription. Le masquage au niveau du côté inférieur 151 peut être réalisé par peinture, ou par fixation d'un feuillet opaque ajouré. Le masquage définit une zone opaque et en correspondance laisse une zone transparente sur le masque, la zone opaque et la zone transparente pouvant elles-mêmes être formées de plusieurs surfaces disjointes, respectivement opaques ou transparentes. Par exemple, la zone transparente peut former un mot qui comporte plusieurs lettres transparentes.

Le côté inférieur peut être adhésivé pour fixer le masque 15 sur la face supérieure 11 du corps principal et/ou sur le diffuseur optique 14.

Dans une autre variante, le masque peut être constitué d'un feuillet adhésif. Des zones ajourées du feuillet peuvent être ménagées pour définir le logo ou l'inscription souhaitée.

Dans un autre mode de réalisation, le logo ou l'inscription peut être défini par des ouvertures ménagées directement dans la face supérieure 11 du corps principal de l'enjoliveur 1.

Dans l'exemple de mode de réalisation ici représenté, une carte électronique 8 regroupe le capteur 4, la source de lumière 6, et un dispositif de commande de l'alimentation de la source de lumière 6 en fonction d'un signal issu du capteur 4. La batterie 7 alimente l'ensemble des éléments consommateurs électriques de la carte électronique 8.

La figure 4 présente un enjoliveur 1 de seuil de porte comportant un dispositif de détection d'un ouvrant conforme à un mode de réalisation de l'invention lorsqu'il ne détecte pas la présence d'un ouvrant. L'enjoliveur 1 est fixé par un adhésif à double face 16 au seuil 2. D'autres modes de fixation sont envisageables, par exemple par collage, vissage, rivetage, ou clipsage.

L'aimant 5 émet un champ magnétique 9 représenté partiellement et schématiquement par des pointillés. L'aimant est un aimant permanent. Un aimant de type néodyme peut être employé. Il peut s'agir d'un aimant cylindrique, par exemple ayant un diamètre de 20 mm et une épaisseur de 3 mm.

Le champ magnétique, en l'absence de déviation, se présente de manière classique comme une série de boucles régulières reliant les pôles de l'aimant. La partie représentée du champ magnétique 9 correspond à la boucle, d'intensité susceptible d'être détectée par le capteur 4.

Le seuil de porte 2, qui est en matériau ferromagnétique (typiquement en acier), dévie la partie inférieure de la boucle du champ magnétique 9.

L'aimant 5 et le capteur 4 de champ magnétique sont positionnés l'un par rapport à l'autre de sorte que, lorsque l'enjoliveur 1 de seuil de porte est fixé sur une surface ferromagnétique telle que le seuil de porte, et en l'absence d'autre élément susceptible de dévier le champ magnétique, la boucle représentée du champ magnétique 9 est détectée par le capteur 4. La partie sensible du capteur 4 est exposée à cette boucle du champ magnétique 9, d'intensité supérieure au seuil de détection du capteur. Le capteur émet un signal correspondant à la détection d'un champ magnétique d'intensité supérieure à son seuil de détection, le circuit électrique est « fermé », et le dispositif de commande de l'alimentation de la source de lumière 6 de la carte électronique 8 commande l'allumage de la source de lumière 6.

En particulier, l'aimant 5 et le capteur 4 peuvent être positionnés dans un même plan, parallèle aux faces inférieure et supérieure du corps principal de l'enjoliveur 1, à l'intérieur de celui-ci. L'aimant 5 et le capteur 4 sont positionnés à distance l'un de l'autre dans un plan orthogonal à l'axe nord-sud de l'aimant.

Lorsqu'un élément ferromagnétique, pouvant être la porte (ou autre ouvrant du véhicule, généralement en acier) est positionné au-dessus de l'aimant 5 (au-dessus de la face supérieure 11 au niveau de l'aimant 5), cet élément ferromagnétique dévie le champ magnétique 9. En particulier, la boucle d'intensité susceptible d'être détectée par le capteur 4 est déviée (de manière analogue à la déviation subie par le champ du fait de la présence d'une surface ferromagnétique (le seuil 2) en partie inférieure du dispositif. Du fait de la déviation de la boucle par ledit seuil 2 d'une part, et par la porte 3 d'autre part (ou tout autre combinaison d'éléments ferromagnétiques en-dessous et au-dessus de l'enjoliveur 1), le capteur 4, ou à tout le moins sa partie sensible, n'est plus exposé à un champ magnétique d'intensité supérieure à son seuil de détection. Le capteur indique la non-détection d'un champ magnétique (par exemple par un signal donné ou une absence signal en sortie), le circuit électrique est « ouvert », et le dispositif de commande de l'alimentation de la source de lumière 6 de la carte électronique 8 commande l'extinction de la source de lumière 6.

La porte 3 (ou autre élément ferromagnétique), doit être amenée à proximité de l'aimant pour pouvoir suffisamment dévier le champ magnétique 9 afin qu'il ne soit plus détecté par le capteur 4. La notion de proximité dépend bien évidemment des caractéristiques des différents éléments du dispositif (taille de l'aimant, intensité de son champ magnétique, sensibilité et positionnement du capteur, etc.). Dans le cadre d'un enjoliveur pour ouvrant de véhicule automobile, la distance entre la face supérieure 11 du dispositif et la surface inférieure de l'ouvrant (venant en regard de l'aimant) peut être de l'ordre de 20 mm au maximum.

Ainsi, lorsque la porte 3 est fermée, la source de lumière est éteinte, et lorsque la porte 3 est ouverte, la source de lumière est allumée.

Lorsque le seuil de porte et/ou la porte ne sont pas constitué en matériau ferromagnétique susceptible de dévier le champ magnétique 9, ce qui peut être le cas par exemple lorsqu'un bas de caisse en plastique est rapporté au véhicule ou que le véhicule comporte une carrosserie en matériau composite, ou en aluminium, l'invention peut être employée en appliquant sous l'enjoliveur 1 et/ou sous la porte 3 (dans la zone venant en regard de l'aimant 5 lorsque la porte est fermée) une couche ferromagnétique, par exemple un adhésif métallique adéquat. La couche rapportée pouvant être très mince et de surface importante, cela ne présente pas les inconvénients (épaisseur, précision nécessaire de positionnement) d'un dispositif comportant un aimant à fixer sous la porte.

Ainsi, tout ouvrant, constitué ou non d'un matériau ferromagnétique, peut être équipé du dispositif de détection d'ouverture et de fermeture d'un ouvrant proposé dans l'invention.

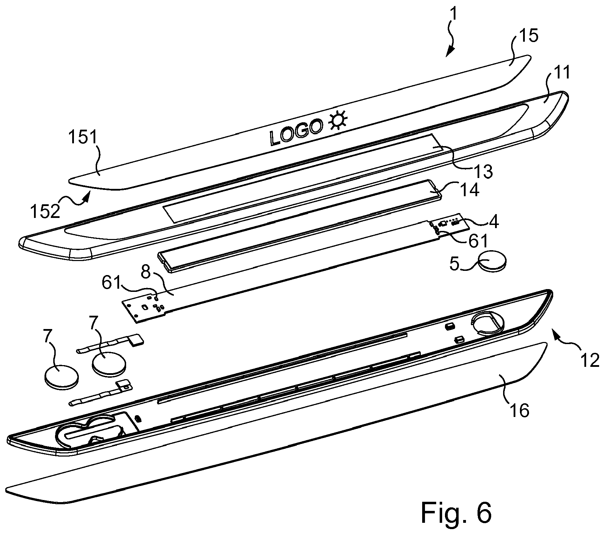

La figure 6 présente sur une vue en éclaté les éléments constitutifs d'un enjoliveur de seuil de porte conforme à un mode de réalisation de l'invention. Dans l'exemple ici représenté, la source de lumière 6 comporte plusieurs diodes électroluminescentes 61 (LED) disposées de part et d'autre de l'ouverture 13. Le diffuseur 14 permet d'homogénéiser l'intensité lumineuse au niveau de toute la surface de l'ouverture 13. Dans l'exemple de mode de réalisation ici représenté, le diffuseur présente sur son pourtour un épaulement, permettant une imbrication de la partie supérieure du diffuseur dans l'ouverture 13. Après montage, la partie supérieure du diffuseur 14 est ainsi à niveau vis-à-vis de la pièce formant la face supérieure 11. Le masque 15, dont le côté inférieur 152 est adhésivé (préférentiellement sur toute sa surface à l'exception de la zone transparente qui forme le logo et/ou l'inscription souhaitée) peut être collé à la fois sur la partie supérieure du diffuseur 14 et sur la pièce formant la surface supérieure 11 de l'enjoliveur 1. Une bonne étanchéité de l'enjoliveur est ainsi garantie au niveau de l'ouverture 13. Le masque 15 peut être constitué d'une plaque rigide ou d'un autocollant souple.

Dans l'exemple de mode de réalisation représenté à la figure 6, la pièce formant la face inférieure 12 de l'enjoliveur 1 et la pièce formant la face supérieure 11 de l'enjoliveur 1 présentent une forme complémentaire sur leur pourtour permettant le clipsage de la pièce formant la face supérieure 11 sur la pièce formant la face inférieure 12. Par exemple, l'une de ces pièces peut comporter une gorge permettant le clipsage de l'autre pièce dans ladite gorge. Une bonne étanchéité peut ainsi être obtenue. Un joint peut le cas échéant être prévu pour parfaire l'étanchéité.

L'adhésif 16 peut présenter une épaisseur non négligeable, par exemple de 0,5mm à 1 mm. Dans ce cas, une bordure de faible épaisseur, inférieure à celle de l'adhésif 16, peut être ménagée sur le pourtour de la face inférieure 12 pour masquer l'adhésif 16.

L'invention propose ainsi un dispositif de détection d'ouverture et de fermeture d'un ouvrant de véhicule fiable et facile à mettre en oeuvre. Le dispositif peut être employé pour tout ouvrant d'un véhicule, notamment pour commander l'allumage et l'extinction d'un dispositif lumineux. Une application préférentielle concerne les enjoliveurs lumineux de seuil de porte.

Un dispositif lumineux, objet de l'invention peut avoir une épaisseur limitée à 5 à 8 mm environ, et ne nécessite pas d'épaisseur d'installation supplémentaire hormis un jeu fonctionnel au-dessus dudit dispositif.

Bien que l'invention ait été précédemment décrite en détails dans un mode de réalisation particulier, de nombreuses variantes et modes de réalisation de l'invention sont envisageables. Par exemple, différentes technologies de capteurs magnétiques peuvent être employées, outre un capteur magnéto-résistif (interrupteur reed, capteur à effet Hall, etc.). Différents types de sources de lumière peuvent également être employés, ainsi que différents types de batteries (piles alcaline, au lithium, batterie rechargeable, etc...) ou de sources électriques.

## Revendications

1. Dispositif de détection d'ouverture et de fermeture d'un ouvrant de véhicule comportant un corps principal contenant un capteur (4) de champ magnétique (9), ledit corps principal comportant une face inférieure (12) et une face supérieure (11),
**caractérisé en ce que** le corps principal contient en outre un aimant (5) permanent, lesdits aimant (5) et capteur (4) étant agencés l'un par rapport à l'autre de sorte que :
- lorsque la face inférieure (12) du corps principal est disposée sur une surface ferromagnétique et qu'aucun élément ferromagnétique n'est positionné à proximité de la face supérieure (11), le champ magnétique (9) généré par l'aimant (5) est supérieur, au niveau du capteur (4), à un seuil de détection dudit capteur (4), et
- lorsque le corps principal est en présence d'un élément ferromagnétique d'un ouvrant de véhicule, positionné en regard de l'aimant (5) à proximité de la face supérieure (11), le champ magnétique (9) est dévié par ledit élément ferromagnétique de sorte qu'il est inférieur, au niveau du capteur (4), au seuil de détection dudit capteur (4).

2. Dispositif de détection selon la revendication 1, dans lequel l'aimant (5) et le capteur (4) sont positionnés sensiblement dans un même plan parallèle à la face inférieure (11) du corps principal du dispositif.

3. Dispositif de détection selon la revendication 1 ou la revendication 2, dans lequel le capteur (4) est de type magnéto-résistif.

4. Dispositif lumineux dont l'allumage et l'extinction sont asservis à l'ouverture et la fermeture d'un ouvrant de véhicule comportant un dispositif de détection selon l'une des revendications précédentes, comportant en outre une source électrique de lumière et une batterie (7), le dispositif lumineux étant configuré de sorte que la source de lumière (6) est alimentée par la batterie (7) lorsque le capteur (4) capte un champ magnétique (9) supérieur à son seuil de détection, et n'est pas alimentée lorsque le capteur (4) ne capte pas de champ magnétique (9) supérieur à son seuil de détection.

5. Dispositif lumineux selon la revendication 4, dans lequel la source de lumière (6) comporte au moins une diode électroluminescente (61).

6. Dispositif lumineux selon la revendication 4 ou la revendication 5, le corps principal du dispositif de détection formant également corps principal du dispositif lumineux, dans lequel la face supérieure (11) comporte au moins une ouverture (13) permettant la sortie de lumière issue de la source de lumière (6).

7. Dispositif lumineux selon la revendication 6, comportant un diffuseur optique (14) adapté à répartir une lumière issue de la source de lumière (6) de manière homogène sous l'ouverture (13) de la face supérieure (11).

8. Dispositif lumineux selon la revendication 6 ou la revendication 7, comportant en outre un masque comportant une zone opaque et une zone transparente, ledit masque obturant l'ouverture 13.

9. Dispositif lumineux selon l'une des revendications 4 à 8 comportant une carte électronique intégrant le capteur (4), la source lumineuse, et un dispositif de commande de l'alimentation de la source de lumière (6) en fonction d'un signal issu du capteur (4).

10. Enjoliveur (1) lumineux de seuil de porte pour véhicule automobile comportant un dispositif lumineux selon l'une quelconque des revendications 4 à 9.
